# EUROPEAN PATENT APPLICATION

(11) **EP 4 583 409 A2**
(43) Date of publication of application: **09.07.2025**
(21) Application number: 24219439.7
(22) Date of filing: 12.12.2024
(51) Int. Cl.: H03M 1/74, H04B 10/50

(54) **HIGH-SPEED TRANSMITTER CIRCUITRY FOR OPTICAL COMMUNICATION**

(30) Priority: 12.12.2023 US 202363609338 P
(71) Applicant: Marvell Asia Pte Ltd, Singapore 369522 (SG)
(72) Inventor: Ray, Sagar, Fremont, CA 94539 (US); Gurumoorthy, Vivekananth, Fremont, CA 94538 (US); Giridharan, Vishal, Milpitas, CA 95035 (US); Dallaire, Stephane, Winnipeg, MB, R3R 3A8 (CA)
(74) Representative: Grünecker Patent- und Rechtsanwälte PartG mbB

(57) **Abstract**

An optical transmitter includes a DAC, a timing circuit, and circuitry. The DAC includes switches configured to convert digital data into analog data that is modulated into an optical signal for transmission over an optical fiber. The timing circuit is configured to generate timing signals to control the switches of the DAC. The circuitry is configured to control an output data rate of the DAC by biasing the switches based on a logical combination of the digital data and the timing signals. An optical transmitter includes DACs and a driver. The DACs are configured to receive digital data at a first data rate and to output currents at a second data rate that is greater than the first data rate. The driver is configured to receive a combined current comprising the currents output by the DACs and to generate an output signal that is proportional to the combined current.

## Description

### CROSS-REFERENCE TO RELATED APPLICATIONS

This application claims the benefit of U.S. Provisional Application No. 63/609,338, filed on December 12, 2023. The entire disclosure of the application referenced above is incorporated herein by reference.

### FIELD

The present disclosure relates generally to optical communication systems and more particularly to high-speed transmitter circuitry for optical communication systems.

### BACKGROUND

The background description provided herein is for the purpose of generally presenting the context of the disclosure. Work of the presently named inventors, to the extent the work is described in this background section, as well as aspects of the description that may not otherwise qualify as prior art at the time of filing, are neither expressly nor impliedly admitted as prior art against the present disclosure.

An optical communication system comprises an optical transmitter and an optical receiver connected by an optical fiber. The optical transmitter modulates an optical signal (e.g., laser), which is a carrier, with the data to be transmitted and transmits the modulated optical signal via the optical fiber. The optical receiver receives the modulated optical signal via the optical fiber and extracts the data from the modulated optical signal.

### SUMMARY

An optical transmitter comprises a digital-to-analog converter (DAC), a timing circuit, and circuitry. The DAC comprises switches configured to convert digital data into analog data that is modulated into an optical signal for transmission over an optical fiber. The timing circuit is configured to generate timing signals to control the switches of the DAC. The circuitry is configured to control an output data rate of the DAC by biasing the switches based on a logical combination of the digital data and the timing signals.

In other features, by the biasing of the switches of the DAC based on the logical combination of the digital data and the timing signals, the DAC outputs the analog data at the output data rate that is greater than a data rate of the digital data.

In other features, by the biasing of the switches of the DAC based on the logical combination of the digital data and the timing signals, the DAC outputs a current signal that is linear regardless of the output data rate of the DAC.

In other features, the timing circuit is configured to generate the timing signals with a phase difference and to adjust the phase difference to control the output data rate of the DAC.

In other features, by adjusting the phase difference of the timing signals, the DAC outputs the analog data at the output data rate that is greater than a data rate of the digital data regardless of a pulse width of the digital data and pulse widths of the timing signals.

In other features, the switches comprise a first switch connected in series to a second switch. The circuitry comprises a combinational logic circuit configured to receive the digital data and the timing signals, to output the logical combination of the digital data and the timing signals to control the first switch, and to control the second switch by a first one of the timing signals.

In other features, the digital data supplies power to the combinational logic circuit.

In other features, the switches further comprise a third switch and a fourth switch. The third switch is connected to the first switch at a node and is biased to output a current signal comprising the analog data. The fourth switch is connected to the node and is biased using a second one of the timing signals to pull up a voltage at the node when the first switch and the second switch turn off.

In other features, the optical transmitter further comprises a bias control circuit configured to control biasing of the third switch to control an output swing of the DAC.

In still other features, an optical transmitter comprises a plurality of digital-to-analog converters (DACs) and a driver. The DACs are configured to receive digital data at a first data rate and to output currents at a second data rate that is greater than the first data rate. The driver is configured to receive a combined current comprising the currents output by the DACs and to generate an output signal that is proportional to the combined current.

In other features, the optical transmitter further comprises a timing circuit and circuitry. The timing circuit is configured to generate timing signals to control the DACs. The circuitry is configured to control the second data rate by biasing the DACs based on a logical combination of the digital data and the timing signals.

In other features, the timing circuit is configured to generate the timing signals with a phase difference and to adjust the phase difference to control the second data rate.

In other features, the optical transmitter further comprises a bias control circuit configured to control biasing of the DACs. An output swing of the driver varies linearly with the biasing of the DACs.

In other features, the driver comprises a current-to-voltage converter, a preamplifier, an amplifier, and a balancing circuit. The current-to-voltage converter is configured to convert the combined current to a voltage signal and to compensate for capacitive loading from the DACs. The preamplifier is configured to amplify the voltage signal and to lower an output impedance of the preamplifier. The amplifier is configured to amplify an output of the preamplifier. The balancing circuit is configured to balance voltages at a plurality of nodes in the amplifier using a combination of feedback and reference voltages to maintain linearity of the output of the amplifier and to lower power consumption of the driver.

In other features, the current-to-voltage converter comprises a T-coil with a center tap configured to receive the combined current and to compensate for the capacitive loading from the DACs.

In other features, the preamplifier comprises a source follower configured to amplify the voltage signal and comprises an LC circuit forming a negative feedback loop configured to lower the output impedance of the preamplifier.

In other features, the amplifier comprises cascoded switches configured to reduce capacitive loading on the preamplifier.

In other features, the amplifier is configured to generate differential outputs via respective termination resistors. The amplifier comprises cascoded switches configured to maintain the output impedance of the amplifier defined by the termination resistors to reduce signal reflections in the differential outputs of the amplifier.

In other features, the amplifier is configured to generate differential outputs through a first set of switches arranged in a first branch and a second set of switches in a second branch. The amplifier comprises a first node (N2) defined by top and bottom switches in the first and second branches and configured to receive the output of the preamplifier. The amplifier comprises a second node (N3) defined by the bottom switches in the first and second branches and configured to bias the bottom switches. The amplifier comprises two termination resistors connected to each other at a third node (N4) and to the differential outputs, respectively. The amplifier comprises cascode switches connected between the top and bottom switches in the first and second branches and biased to reduce capacitive loading on the preamplifier and to maintain the output impedance of the amplifier defined by the termination resistors.

In other features, to maintain linearity of the output of the amplifier and to lower power consumption of the driver, the balancing circuit comprises a first circuit, a second circuit, and a third circuit. The first circuit is configured to generate a power supply voltage supplied to the DACs and the current-to-voltage converter and to regulate the power supply voltage at the first node (N2) to keep the bottom switches of the first and second branches within linear operating region. The second circuit is configured to sense a common-mode output voltage of the amplifier and to generate a feedback signal that is input to the second node (N3). The feedback signal is configured to control biasing of the bottom switches in the first and second branches so that bias currents of the bottom switches are equal to bias currents of the cascode switches. The third circuit is coupled to the third node (N4) and is configured to control low frequency common-mode return loss of the driver to mitigate common mode reflections from the differential outputs and to generate a controllable voltage difference across the termination resistors that provides a bias current to add to or subtract from currents of the cascode switches that flow though the bottom switches.

In other features, the amplifier is configured to generate differential outputs via respective T-coils configured to isolate the differential outputs from external electrostatic discharge (ESD) protection devices and to reduce capacitive loading on the differential outputs from the ESD devices.

Further areas of applicability of the present disclosure will become apparent from the detailed description, the claims and the drawings. The detailed description and specific examples are intended for purposes of illustration only and are not intended to limit the scope of the disclosure.

### BRIEF DESCRIPTION OF DRAWINGS

FIG. 1 is a block diagram of an optical communication system.
FIG. 2 is a functional block diagram of an optical transmitter of the optical communication system of FIG. 1.
FIGS. 3A and 3B are functional block diagrams of a digital-to-analog converter (DAC) used in the optical transmitter of FIG. 2.
FIG. 4A is a circuit diagram of the DAC used in the optical transmitter of FIG. 2.
FIG. 4B shows an example of a current mirror used to generate a bias voltage for the DAC of FIG. 4A.
FIG. 5A is a timing diagram of the DAC of FIG. 4A.
FIG. 5B is a truth table for the DAC of FIG. 4A.
FIG. 5C is a graph showing linearity of output swing of the optical transmitter of FIG. 2.
FIG. 6 is a functional block diagram of a driver used in the optical transmitter of FIG. 2.
FIGS. 7-10 show various circuits of the driver of FIG. 6.

In the drawings, reference numbers may be reused to identify similar and/or identical elements.

### DESCRIPTION

Due to recent surge in artificial intelligence (Al) and machine learning (ML) applications along with cloud computing, demand for high-speed and high-bandwidth optical communication systems in data centers is increasing. These applications continue to push for higher throughput in network components such as transmitter and receiver front-end circuitry used in optical communication systems in data centers. Moreover, the high density of optical modules in hardware-racks used in data-centers require innovative low-power design techniques for power-hungry transceiver chips used in optical communication systems in data centers. To address the demand for these applications without drastic increase in number of optical ports and implementation cost, data rates of 200 Gbps or more are desired , which is twice the data rates of current generation transceivers. It is difficult to achieve this sort of bandwidth without additional hardware, which increases both power consumption and cost. The problem of achieving high bandwidth along with high-swing/low-power dissipation in transmitter design for optical communication applications is addressed in the present disclosure.

In various commercially available optical communication systems that comply with one or more IEEE standards (e.g., IEEE P802.3dj), an optical transmitter uses up to eight channels with each channel outputting data at about 100Gbps. The optical transmitter combines the outputs of the eight channels to transmit data at 800Gbps. Each channel uses a digital-to-analog converter (DAC) comprising a single device to convert bits of digital data into an analog signal. Specifically, each DAC includes a single switching device (e.g., a single transistor) that operates in a voltage mode. In the voltage mode, an input data signal to the DAC and an output data signal of the DAC are voltage signals of the same phase.

There are various shortcomings with the above transmitter architecture. The data rate of each channel is limited to 100Gbps and it is hard to scale the data rate with this architecture. This is because pulse width of the input signal to the DAC would need to be halved in order to double the data rate. However, halving the pulse width of the input signal is challenging for many reasons. For example, additional circuitry is required to halve the pulse width of the input signal and to maintain the halved pulse width of the input signal, which increases the power consumption of the optical transmitter. Additionally, the amplitude (voltage level or swing) of the output signal of the DAC does not change linearly with that of the input signal. Further, the relationship between the input and output signals of the DAC changes considerably over temperature, process, and chip-to-chip variations. Consequently, due to practicality, in order to double the data rate of the transmitter, another set of 8 channels along with related hardware needs to be added to the optical transmitter, which not only consumes more power but adds to equipment cost.

Teachings of the present disclosure enable the data rate of each channel to be doubled and even scaled higher without sacrificing linearity and without any dramatic increase in power consumption of the optical transmitter. Specifically, the data rate of each channel is doubled by using a DAC operating in current mode instead of in voltage mode, which thus eliminates the need to double the number of channels (i.e., the amount of hardware) to thereby double the data rate of the optical transmitter.

As described below in detail, the DAC uses two series-connected switches instead of one switch and employs circuitry (e.g., a NAND gate) that drives the two switches using a logical combination of two clock signals and digital data. The pulse width of the output current of the DAC can be scaled by scaling a phase difference between the two clock signals. Operating the DAC in the current mode allows using lower power, and the phase-difference based design instead of a pulse-width based design relaxes timing constraints on the input signals. Specifically, the input signals (e.g., digital data and clock signals) can have wider pulse widths (i.e., lower frequencies) and yet by controlling the phase offset between the clocks used to drive the DAC, the output current pulses of the DAC can be narrowed, yielding higher output data rates.

The DAC design of the present disclosure is scalable to provide even more than the doubled data rates by only controlling the phase offset (phase difference) between the clocks used to drive the DAC. Additionally, the output current of the DAC can be controlled linearly by using a current mirror similar to the DAC. The temperature and process variations are managed due to inherent matching between the current mirror and the DAC.

Additionally, the present disclosure also discloses a driver that converts high-frequency current signals output by the DACs to a proportional voltage that can drive an external load (e.g., the optical devices). As described below in detail, the driver employes four stages: a current-to-voltage (I-to-V or simply IV) converter stage, a buffer (pre-amplifier) stage, a differential amplifier stage, and a balancing stage. Many innovative features are provided by these stages, which are described below in detail.

Briefly, in the IV stage, the current outputs of the DACs are combined and input to a center tap of a coil. The coil compensates for the capacitive loading from the DACs. The buffer stage uses a source follower. In a typical source follower, a bottom switch does not participate in signal modification and only operates as a current source. In contrast, the buffer stage employs an LC circuit that creates a negative feedback loop by reusing current that flows through the bottom switch. Due to the negative feedback, the buffering action of the source follower is enhanced, which allows the source follower to drive higher capacitive load than a typical source follower.

The differential amplifier amplifies the outputs of the buffer stage while using a low supply voltage to reduce power consumption. The differential outputs of the amplifier are supplied to subsequent circuits (e.g., optical modulators, etc.). The differential amplifier includes termination resistances and cascode transistors. The cascode transistors shield the inputs of the amplifier and the buffer stages from being impacted by signal swings within the amplifier due to capacitive Miller effects. The cascode transistors in series with the input transistors also help maintain the effective termination resistances.

The balancing stage employs multiple op-amps. A first op-amp is used to minimize DC voltage variation at the output of the buffer stage and to generate a DC voltage required at the gate of the NMOS devices of the amplifier stage. A second op-amp is used to minimize DC voltage variation at the output of the amplifier stage and to generate a DC voltage required by the drain node of NMOS and PMOS devices of the amplifier stage. A third op-amp is used to improve common mode return loss and to create current offset between the bottom NMOS and the top PMOS branches of the amplifier stage. These and other features of the present disclosure are described below in further detail.

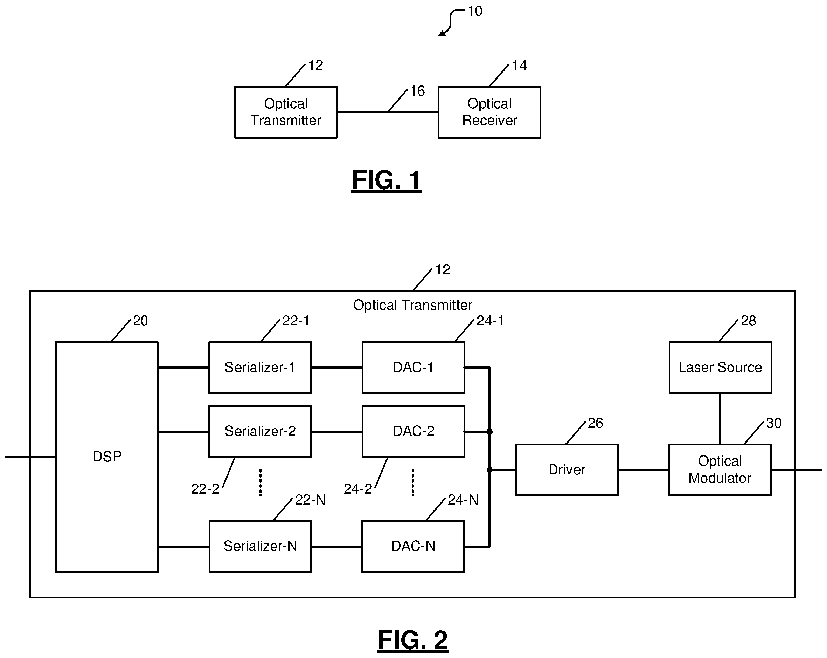

FIG. 1 shows a block diagram of an optical communication system 10. The optical communication system 10 comprises an optical transmitter 12 and an optical receiver 14 connected by an optical fiber 16. The optical transmitter 12 is shown in further detail in FIG. 2. The optical transmitter 12 receives data to be transmitted, modulates an optical signal (e.g., laser) with the data, and transmits the modulated optical signal via the optical fiber 16. The optical receiver 14 receives the modulated optical signal via the optical fiber 16 and extracts the data from the modulated optical signal.

FIG. 2 shows the optical transmitter 12 in further detail. The optical transmitter 12 comprises a digital signal processor (DSP) 20; a plurality of serializers 22-1, 22-2, ..., and 22-N (collectively called the serializers 22), where N is a positive integer (e.g., N = 8); a plurality of DACs 24-1, 24-2, ..., and 24-N (collectively called the DACs 24); a driver 26; a laser source 28; and an optical modulator 30. In addition, while not shown, the optical transmitter 12 comprises a power supply that generates all of the power supply voltages required by the components of the optical transmitter 12 (e.g., power supply voltages, bias voltages, and reference voltages described below).

The DSP 20 receives digital data (bits) to be transmitted. The DSP 20 splits the data into multiple data streams of bits. Each of the serializers 22 serializes the bits in the respective data streams and outputs serial data. Each of the DACs 24 converts the serial data received from the respective serializer and outputs a current signal. The current signals from the DACs 24 are combined and input to the driver 26.

The driver 26 converts the combined current signals output by the DACs 24 to a proportional voltage that can drive an external load (e.g., the optical fiber 16). The driver 26 generates a modulating signal based on the combined current signals output by the DACs 24. The driver 26 outputs the modulating signal to the optical modulator 30.

The laser source 28 generates an optical signal (e.g., laser) that is used as a carrier by the transmitter 12 to transmit data. The optical modulator 30 modulates the optical signal with the modulating signal received from the driver 26 and generates a modulated optical signal. The transmitter 12 transmits the modulated optical signal via the optical fiber 16.

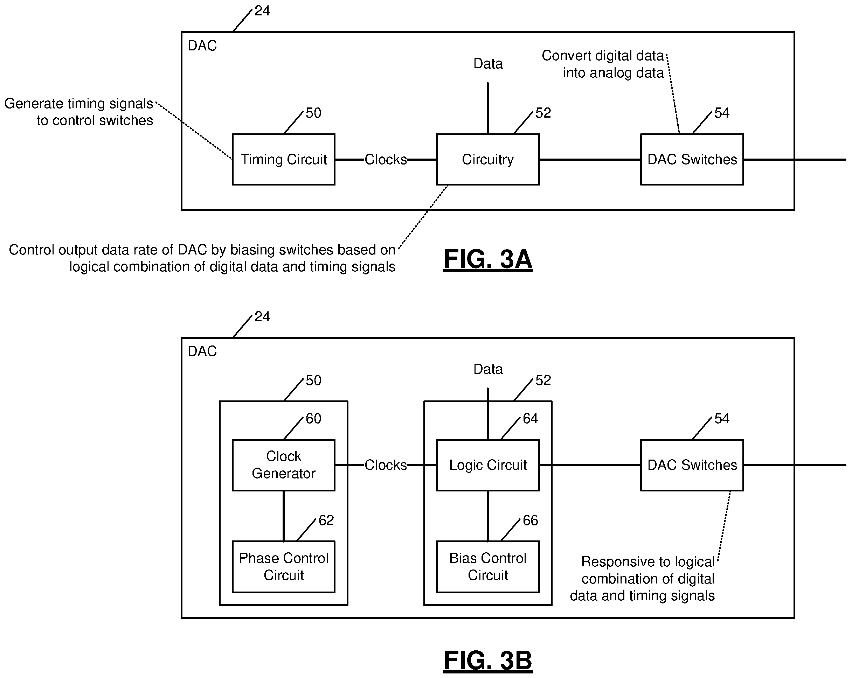

FIGS. 3A and 3B show a design of the DACs 24. Each DAC 24 shown in FIG. 2 comprises the components shown in FIGS. 3A and 3B. In the following description, each individual DAC 24 shown in FIG. 2 is referred to as the DAC 24. The following description applies to each of the DACs 24 shown in FIG. 2. In FIG. 3A, the DAC 24 comprises a timing circuit 50, circuitry 52, and DAC switches 54. In FIG. 3B, the timing circuit 50 comprises a clock generator 60 and a phase control circuit 62. The circuitry 52 comprises a logic circuit 64 and a bias control circuit 66. In some embodiments, the clock generator 60, the phase control circuit 62, and the bias control circuit 66 may be common to all the DACs 24 shown in FIG. 2. That is, in some embodiments, only one clock generator 60, only one phase control circuit 62, and only one bias control circuit 66 may be used to drive all the DACs 24 shown in FIG. 2.

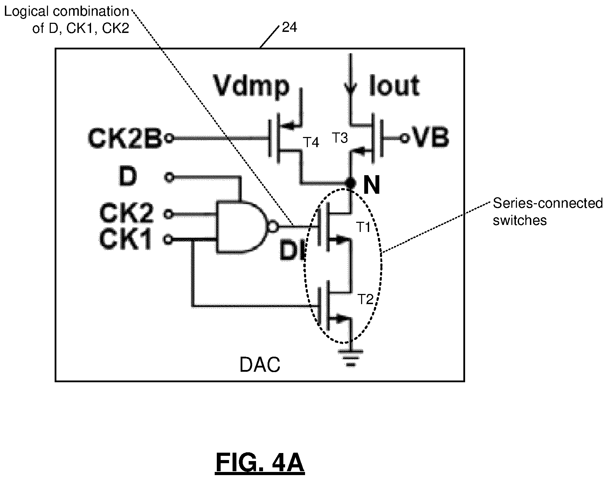

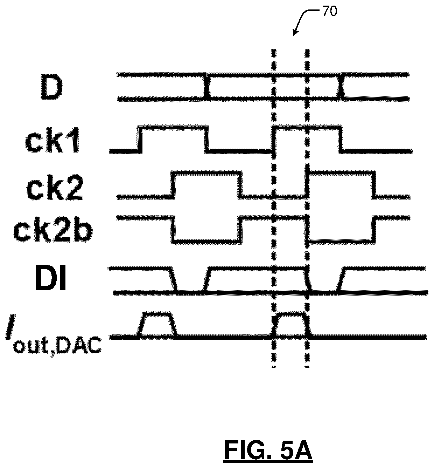

The DAC 24 is configured to convert digital data into analog data that is modulated by the optical modulator 30 (shown in FIG. 2) into an optical modulated signal for transmission over the optical fiber 16 (shown in FIG. 1). The timing circuit 50 is configured to generate timing signals to control the DAC switches 54. In the timing circuit 50, the clock generator 60 generates timing signals (e.g., clock signals) to control the DAC switches 54. As described below in detail with reference to FIGS. 4A and 5A-5B, the phase control circuit 62 controls a phase difference (shown at 70 in FIG. 5A) between the clock signals to control an output data rate of the DAC 24. Accordingly, the timing circuit 50 generates the timing signals that include clock signals with a phase difference and adjusts the phase difference to control the output data rate of the DAC 24 as described below in further detail.

In the circuitry 52, the logic circuit 64 (e.g., a NAND gate-based circuit shown in FIG. 4A) receives the clock signals output by the timing circuit 50 with a phase difference tuned (selected) by the phase control circuit 62 to achieve a desired output data rate of the DAC 24. The logic circuit 64 also receives the digital data D output by the respective serializer 22 (shown in FIG. 2). The circuitry 52 is configured to control the output data rate of the DAC 24 by biasing the DAC switches 54 based on a logical combination of the digital data and the timing signals as described below in further detail with reference to FIGS. 4A and 5A-5B.

By biasing the DAC switches 54 based on the logical combination of the digital data and the timing signals, the DAC 24 outputs analog data having a data rate that is greater than a data rate of the digital data. For example, by selecting a suitable phase difference between the clock signals used to drive the DAC switches 54, which is selected based on the desired output data rate of the DAC 24, the output data rate of the DAC 24 can be more (e.g., twice or even higher) than the data rate of the digital data.

By adjusting the phase difference of the timing signals using the phase control circuit 62, the DAC 24 outputs data at a data rate that is greater than the data rate of the digital data regardless of the pulse widths of the timing signals and a pulse width of the digital data. The phase difference between the clock signals can be tuned to scale the output data rate of the DAC 24. Controlling the output data rate of the DAC 24 by adjusting the phase difference of the timing signals relaxes timing constraints on the digital data and the timing signals. Accordingly, the output data rate of the DAC 24 can be scaled without imposing constraints on the timing (e.g., without narrowing pulse widths of) of the digital data and the timing signals.

Additionally, by biasing the DAC switches 54 based on the logical combination of the digital data and the timing signals, the DAC 24 outputs a current signal that is linear regardless of the output data rate of the DAC 24. Specifically, the DAC 24 does not operate in voltage mode, where input and output of the DAC are synchronized voltage signals, and where achieving linearity of the DAC output at higher data rates is challenging as explained below. Instead, the DAC 24 operates in current mode using two series-connected switches (shown in FIG. 4A), where the inputs (the digital data and the timing signals) to the DAC 24 are voltage signals but the output parameter of interest of the DAC 24 is a current signal of smaller pulse width compared to the input voltage signals. The current signal output by the DAC 24 varies linearly regardless of the output data rate of the DAC 24 and regardless of the pulse widths of the digital data and the timing signals as explained below.

More specifically, to save power and increase the output data rate of the DAC, a smaller voltage pulse is typically required to control the DAC. In voltage mode, the pulse width of the input signal to the DAC needs to be at least two times smaller than in current mode. Narrower voltage pulses required in voltage mode to increase the output data rate of the DAC are difficult to generate and maintain (e.g., additional circuitry is needed, which increases power consumption). In addition, voltage mode is disadvantageous for swing control since the output signal amplitude (voltage swing) of the DAC does not change linearly with input signal amplitude. Many applications require the ability to linearly control the swing of the output of the DAC, which is difficult to achieve in voltage mode, particularly as changing the pulse height of the input signal to change swing also changes the bandwidth. Accordingly, in voltage mode, the ability to improve bandwidth is coupled to change of the output voltage swing of the DAC.

In contrast, current mode has none of these limitations. This is because the output current of the DAC switches 54 is controlled by driving the DAC switches 54 using the logical combination of the digital data and the timing signals. By varying the phase difference of the timing signals, the logical combination of the digital data and the timing signals can vary the output current of the DAC 24 linearly regardless of the pulse widths of the digital data and the timing signals. Accordingly, unlike voltage mode, in current mode, the output current of the DAC 24 is independent of the pulse heights of the digital data and the timing signals (up to a certain limit). The pulse width of the output data of the DAC 24 can be varied linearly by adjusting the phase difference between the clock signals without regard to the pulse widths of the digital data and the timing signals and without increasing power supply voltage, which reduces power consumption. Accordingly, by operating the DAC 24 in current mode, driving the DAC 24 by the logical combination of the digital data and the timing signals, and controlling the phase difference between the clock signals, the output data rate of the DAC 24 can be increased linearly without increasing power consumption while relaxing the timing constraints on the inputs of the DAC 24.

FIGS. 4A-4B and 5A-5B show an example of implementation of the DAC 24 shown in FIGS. 3A and 3B. The DAC 24 comprises switches T1, T2, T3, and T4 (the DAC switches 54 shown in FIGS. 3A and 3B); and a NAND gate (the circuitry 52 shown in FIGS. 3A and 3B). The timing circuit 50 shown in FIGS. 3A and 3B generates the clock signals CK1 and CK2 shown in FIG. 5A. For example, the clock generator 60 shown in FIG. 3B generates the clock signals CK1 and CK2, and the phase control circuit 62 shown in FIG. 3B controls the phase difference 70 between the clock signals CK1 and CK2 based on the desired output data rate of the DAC 24.

The DAC 24 comprises the switches T1 and T2 connected to each other in series. The switches T3 and T4 are connected to the switch T1 at a node N as shown in FIG. 4A. The node N is called a source node since the node N is at a source terminal of the switch T1. The switch T3 is called a biasing switch, and the switch T4 is called a pullup switch. The operations of the switches T3 and T4 are described below.

The NAND gate receives two inputs and receives an input as a power supply for the NAND gate. The two inputs to the NAND gate are the two clock signals CK1 and CK2 generated by the timing circuit 50 shown in FIGS. 3A and 3B. The digital data D output by the serializer 22 (shown in FIG. 2) is applied to the NAND gate as the power supply of the NAND gate. The NAND gate generates an output DI based on the two inputs CK1 and CK2 of the NAND gate and the digital data D, which is the power supply of the NAND gate.

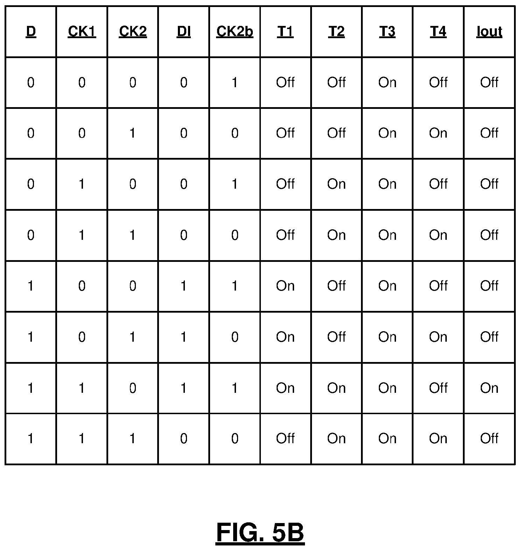

Since the digital input D is applied to the NAND gate as the power supply of the NAND gate, the output DI of the NAND gate is 0 when the digital data D supplying power to the NAND gate is 0 since there cannot be any output when the power supply to the NAND gate is 0. The NAND gate switches the output DI according to the input clock signals CK1 and CK1 when the digital data D supplying power to the NAND gate is 1 as shown in a truth table shown in FIG. 5B. The output DI of the NAND gate drives the switch T1. The clock signal CK1 drives the switch T2. The switches T1 and T2 generate an output current lout, which is an analog output of the DAC 24 representing the digital data D. Since the DAC 24 outputs a current signal representing the digital data D, the DAC 24 is said to operate in current mode.

FIG. 5A shows a timing diagram of the signals shown in FIG. 4A. FIG. 5B shows a truth table of the DAC 24. The truth table shows the on/off states of the switches T1 through T4 when the switches T1 through T4 are operated using the signals shown in the timing diagram of FIG. 5A.

In FIG. 5A, the phase difference between the two clock signals CK1 and CK2 is shown at 70. The pulse width of the output current lout of the DAC 24 is proportional to the phase difference 70 between the two clock signals CK1 and CK2. Accordingly, the output data rate of the DAC 24 can be controlled by controlling the phase difference 70 between the two clock signals CK1 and CK2.

The clock signals CK1 and CK2 have the same frequency, which is also the same as the frequency of the digital data D. However, the clock signals CK1 and CK2 are offset in phase relative to each other by the phase difference 70. The clock signals CK1 and CK2 respectively have a 50% duty cycle. That is, in the clock signals CK1 and CK2, the pulse widths of the high and low pulses in one clock cycle are the same. The clock signal CK2b is an inverted clock signal CK2.

To adjust the output data rate of the DAC 24, the phase difference 70 between the clock signals CK1 and CK2 can be adjusted to any value that is less than the pulse width of the clock signals CK1 and CK2. To provide more room for scaling the output data rate of the DAC 24, which is proportional to the phase difference 70, the pulse width of the clock signals CK1 and CK2 can be increased (i.e., the frequency of the clock signals CK1 and CK2 can be reduced). The increased pulse width of the clock signals CK1 and CK2 can in turn provide more room within which to vary the phase difference 70 to vary the output data rate of the DAC 24. The phase control circuit 62 may be programmable to select the pulse width of the clock signals CK1 and CK2. For example, a codeword can be input to the phase control circuit 62 to set the pulse width of the clock signals CK1 and CK2.

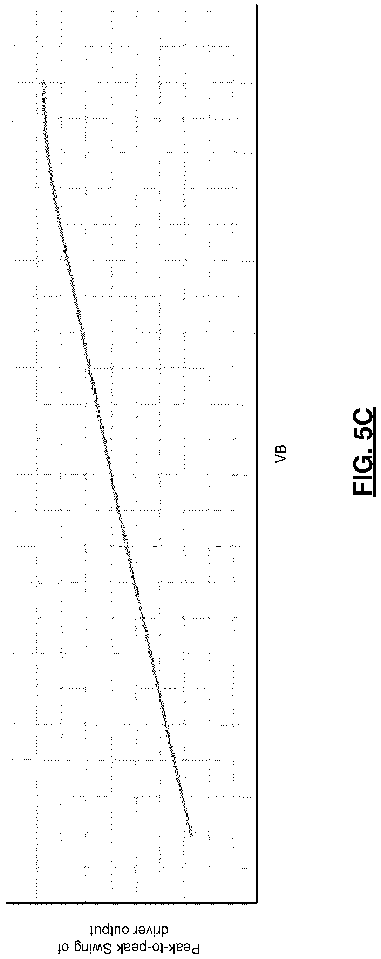

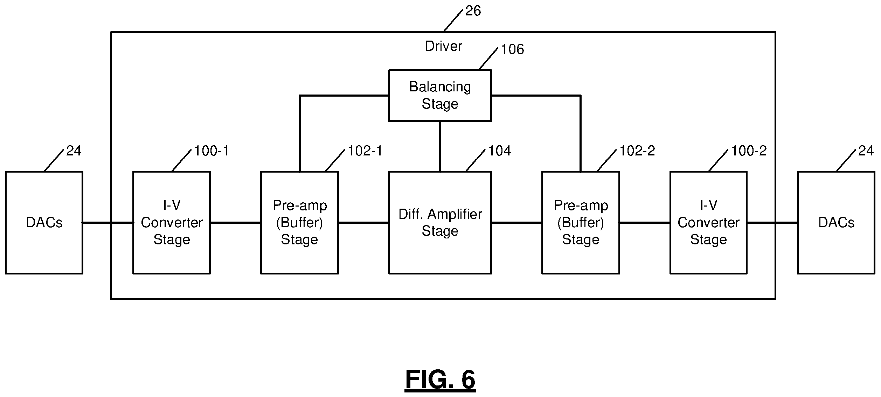

The bias switch T3 is biased by a bias voltage VB. The bias control circuit 66 shown in FIG. 3B controls the bias voltage VB supplied to the bias switch T3. The bias voltage VB determines the output swing of the DAC 24, which in turn determines the output swing of the driver 26 shown in FIG. 2. The driver 26 maintains the linearity of the current output by the DACs 24 as described below with reference to FIGS. 6-10. The output swing of the driver 26 can be linearly controlled by controlling the bias voltage VB as shown in FIG. 5C, which is useful in optical applications as explained below.

In optical applications, in different optical transmitters, the downstream circuits from the driver 26 (e.g., an additional external driver, the modulator 30, etc.) may exhibit optimal performance at different swing levels of the driver 26. The optical transmitter should be able to select the amplitude (swing level) of the driver 26 suitable for the downstream circuits without compromising performance (e.g., linearity and low power consumption) provided by the DACs 24 and the driver 26. This is difficult to achieve when the DACs operate in voltage mode due to non-linearity of the voltage output of the DACs.

Instead, when the DACs 24 operate in current mode, the bias control circuit 66 can control the bias voltage VB based on the swing requirements of the circuits following the driver 26 without compromising the performance provided by the DACs 24 and the driver 26. As seen in FIG. 5C, the output swing of the driver 26 varies linearly with the bias voltage VB of the DACs 24 over an operating range. The performance of the driver 26 (e.g., including signal-to-ripple ratio) is insensitive to the swing amplitude (peak-to-peak output) of the driver 26.

The bias control circuit 66 can be programmable to select the bias voltage VB of the DACs 24 that is suitable for different optical applications. For example, a codeword can be input to the bias control circuit 66 to set the bias voltage VB of the DACs 24. For example, the bias control circuit 66 may comprise a low-speed biasing DAC that generates the bias voltage VB based on the codeword. Alternatively, the bias control circuit 66 may comprise a voltage divider (e.g., a resistive ladder) with taps connected to switches through which different bias voltages VB can be output to the DACs 24. The switches can be controlled using the codeword to select the bias voltage VB of the DACs 24.

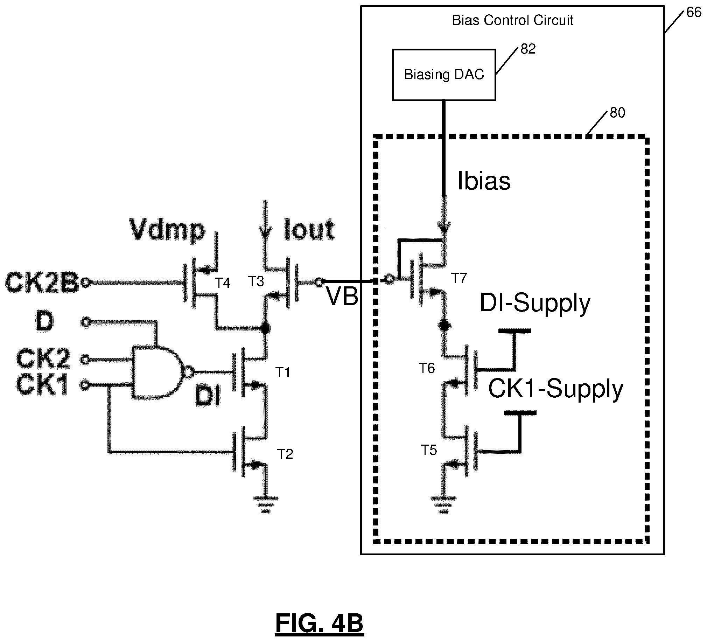

FIG. 4B shows a current mirror circuit 80 as another example of the bias control circuit 66 that can be used to generate the bias voltages VB for the DAC 24. The current mirror circuit 80 comprises series-connected switches T5 and T6 that are replicas of the switches T1 and T2 of the DAC 24, respectively. A switch T7 is connected in series to a source of the switch T2 and is a replica of the switch T3 of the DAC 24. The drain and gate of the switch T7 are connected to each other in a current mirror configuration. A switch similar to the switch T4 of the DAC 24 is not needed in the current mirror circuit 80 since the switch T4 is turned off when the current lout of the DAC 24 is flowing. Using the switches T5, T6, and T7 in the current mirror circuit 80 as replicas of the respective switches T1, T2, and T3 of the DAC 24 reduces the temperature and process variations in the DACs 24 due to inherent matching between the current mirror circuit 80 and the DAC 24.

The output DI of the NAND gate of the DAC 24, which drives the switch T2 of the DAC 24 varies between 0V and a supply voltage DI-Supply. The constant voltage Dl-supply drives the switch T6 of the current mirror circuit 80. The clock CK1, which drives the switch T1 of the DAC 24, varies between 0V and a voltage CK1-Supply. The constant voltage CK1-Supply drives the switch T5 of the current mirror circuit. A biasing DAC 82 (e.g., a low-speed biasing DAC similar to that described above with reference to the bias control circuit 66) supplies a bias current Ibias through the switch T7 of the current mirror circuit 80. The switch T7 functions as a diode with its drain and gate connected to each other. A voltage VB to sustain the bias current is generated across the switch T7. When the voltage VB generated across the switch T7 is applied to the gate of the switch T3 of the DAC 24, which is matched to the switch T7 of the of the current mirror circuit 80, the same current that flows through the switch T7 is generated through the switch T3 of the DAC 24. Thus, the bias current is mirrored in the DAC 24.

Specifically, there is a proportional relationship between the bias current Ibias that flows through the current mirror circuit 80 and the current lout that flows through the DAC 24. For a given digital data input to the DAC 24, increasing Ibias by N times increases lout by N times, which increases the swing of the DAC 24 by N times. Thus, the value of Ibias is linearly proportional to the codeword input to the low-speed biasing DAC 82, and the bias voltage VB of the DAC 24 is programmed by programming Ibias (by controlling the controlling the codeword input to the biasing DAC 82 that generates Ibias). Accordingly, by controlling the codeword input to the biasing DAC 82 that generates Ibias, the current lout of the DAC 24 can be linearly controlled. Further, by controlling the codeword input to the biasing DAC 82 that generates Ibias, the bias voltage VB of the DAC 24 is also linearly controlled, which in turn linearly controls the swing of the output of the DAC 24 and the driver 26.

The pullup switch T4 is driven by the clock signal CK2b. The pullup switch T4 pulls up the voltage at the source node N high to Vdmp when the DAC switches T1 and T2 turn off (when all inputs of the NAND gate - D, CK1, and CK2 - are high). Pulling up the source node N high when the DAC switches T1 and T2 turn-off sharpens the fall time of the output current lout of the DAC 24 and increases operating speed of the DAC 24.

The switch T2 is controlled by the clock signal CK1 instead of by the switch T2. This is because the voltage level of the clock signal CK1 can be less than that of the output DI of the NAND gate to reduce power dissipation. The switch T2, which is a source-grounded NMOS device, can be turned on and off easily and faster by using a lower voltage signal such as the clock signal CK1. By driving the switches T1 to T4 of the DAC 24 as described above, a 1 unit-interval (1UI) pulse of the digital data D is converted to a high-speed current pulse I_{out,DAC} as shown in FIG. 5A.

Using N DACs 24 as shown in FIG. 2, outputs of serializers 22 running at 1/Nth of the desired data rate are converted to currents by the N DACs 24. The currents output by the DACs 24 are combined and amplified by the driver 26 shown in FIG. 2 to generate an output at the desired data rate. The desired data rate at the output of the DACs 24 can be set by selecting the phase difference 70 of the clock signals CK1 and CK2. Using the phase difference 70 to scale the output data rate of DAC 24 eliminates the need to narrow the pulse widths of any of the inputs to the NAND gate - digital data D and the two clocks CK1 and CK2 - which eliminates the need for additional hardware, which in turn reduces power consumption. Further, since the output current lout of the DAC 24 varies linearly when the phase difference 70 of the two clocks CK1 and CK2 is adjusted based on the desired output data rate of the DAC 24, the output data rate of the DAC 24 can be scaled linearly.

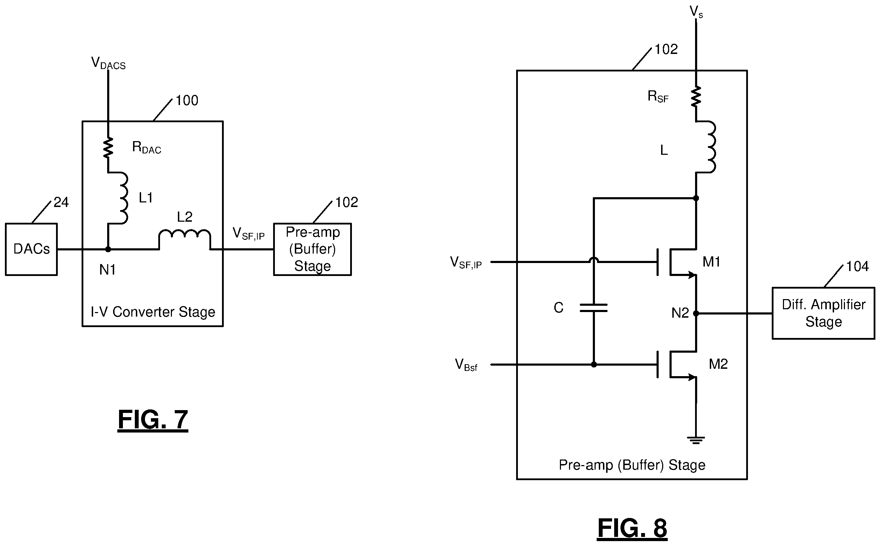

FIG. 6 shows a functional block diagram of the driver 26. The driver 26 receives the combined current of the DACs 24, which is a sum of the currents output by the DACs 24, converts the combined current to a voltage signal, and amplifies the voltage signal that is used by the optical modulator 30 (shown in FIG. 2) to generate the optical modulated signal. As explained below with reference to FIGS. 7-10, the driver 26 operates as a transimpedance amplifier (TIA) and performs the conversion and amplification without losing the linearity of the currents output by the DACs 24 and while keeping the power consumption low.

The driver 26 comprises four stages. As described below in detail, a first stage comprises two complementary IV converters 100-1, 100-2. A second stage comprises two complementary preamplifiers (buffers) 102-1, 102-2. A third stage comprises a differential amplifier 104. A fourth stage comprises a balancing circuit 106. The driver 26 uses a differential (instead of a single-ended) design that uses differential inputs (N, P) to produce differential outputs (N, P). Due to the differential design of the driver 26, each stage of the driver 26 comprises two sets of circuits with one set receiving an N input from a previous stage and producing an N output for a next stage, and another set receiving a P input from the previous stage and producing a P output for the next stage.

A first stage of the driver 26 is a current-to-voltage (I-to-V or IV) converter stage comprising IV converters 100-1, 100-2 (collectively called the IV converters 100). A second stage of the driver 26 is a preamplifier (buffer) stage comprising preamplifiers (buffers) 102-1, 102-2 (collectively called the preamplifiers 102). A third stage of the driver 26 is an amplifier stage comprising a differential amplifier 104. A fourth stage of the driver 26 is a balancing stage 106. The four stages of the driver 26 are described below in detail with reference to FIGS. 7-10.

Briefly, the IV converters 100 receive the combined current output by the DACs 24 and convert the combined current to respective voltage signals. The voltage signals output by the IV converters 100 are input to the preamplifiers 102 for preamplification. The outputs of the preamplifiers 102 are fed to the inputs of the differential amplifier 106 for further amplification. The balancing stage 108 balances voltages at various nodes of the driver 26 as described below in detail. In the following description, only one of the IV converters 100 and only one of the preamplifiers 102 are described. The following description of the IV converter 100 applies to both of the IV converters 102-1, 102-2. The following description of the preamplifier 102 applies to both of the preamplifiers 102-1, 102-2.

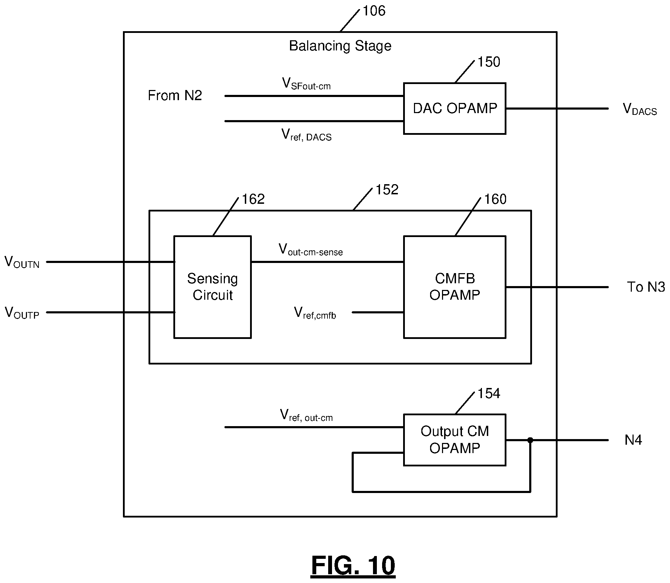

FIG. 7 shows one of the IV converters (called the IV converter) 100. The IV converter 100 comprises a T-coil comprising two series-connected inductors L1 and L2 with a center tap. A node at which the inductors L1 and L2 are connected to each other in series is called N1. The center tap of the T-coil is located at the node N1 and is also called the center tap N1. The inductor L1 is connected to a power supply V_{DACS} that supplies power to the DACs 24. The balancing circuit 106 generates V_{DACS} as described below with reference to FIG. 10. The inductor L2 is connected to the preamplifier 102.

The combined current output by the DACs 24 is input to the center tap N1 of the T-coil. The T-coil compensates for the capacitive loading from the DACs 24, which helps maintain the linearity of the currents output by the DACs 24. The IV converter 100 converts the combined current output by the DACs 24 to a voltage signal that is input to a source follower of the preamplifier 102. A resistive load R_{DAC} of the T-coil defines a conversion gain of the IV converter 100. Due to the differential design of the driver 26, the voltage signals output by the IV converters 100-1, 100-2 are called V_{SF,IP} and V_{SF,IN}, respectively.

FIG. 8 shows the preamplifier 102. The preamplifier 102 comprises a source follower comprising two series connected switches M1 and M2 (e.g., NMOS switches). A node at which the switches M1 and M2 are connected to each other in series is called N2. The switch M1 is called a top switch, and the switch M2 is called a bottom switch. The output of the preamplifier 102 at the node N2 is connected to an input of the amplifier 104. The bottom switch M2 is biased by a source follower bias voltage called V_{Bsf}.

The preamplifier 102 further comprises an LC circuit comprising an inductor L and a capacitor C. The inductor L is connected between the top switch M1 and a power supply Vs. The capacitor C is connected between a control terminal (gate) of the bottom switch M2 and an end of the inductor L that is connected to the top switch M1. The LC circuit creates a negative feedback loop by reusing current that flows through the bottom switch M2. The negative feedback loop comprising the LC circuit is designed such that the preamplifier 102 does not oscillate. Due to the negative feedback, the buffering action of the source follower is enhanced, due to which the source follower can drive a higher capacitive load than a typical source follower that does not use the negative feedback. The negative feedback helps maintain the linearity of the currents output by the DACs 24.

Specifically, the capacitor C is a high-speed capacitor, and the inductor L is a shunt-peaking inductor L. For example, the high-speed capacitor C is a metal-to-metal capacitor that has a low parasitic (unwanted) capacitor to substrate. The high-speed capacitor C also has high self-resonance frequency (SRF) and low equivalent series resistance (ESR). The shunt peaking inductor L shunts current initially when the current is trying to change due to any parasitic capacitor connected to that node. As a result, the effect of the parasitic capacitance is reduced and the circuit becomes faster. Usually, shunt peaking inductors are used in series with a load resistor (e.g., R_{SF}).

The feedback path is AC coupled using the high-speed capacitor C to ensure that the loop bandwidth is sufficiently high to maintain the linearity of the driver 26. The shunt-peaking inductor L is connected to the drain of the top switch M1 in series with a resistor R_{SF} to increase loop gain at high frequencies so that the output impedance of the preamplifier 102 at the source of the top switch M1 (at node N2) stays low in the presence of parasitic capacitances at different nodes in the driver 26. The low frequency loop gain of the preamplifier 102 is gₘ₂R_{SF}, where gₘ₂ is the transconductance (voltage to current gain) of the bottom switch M2.

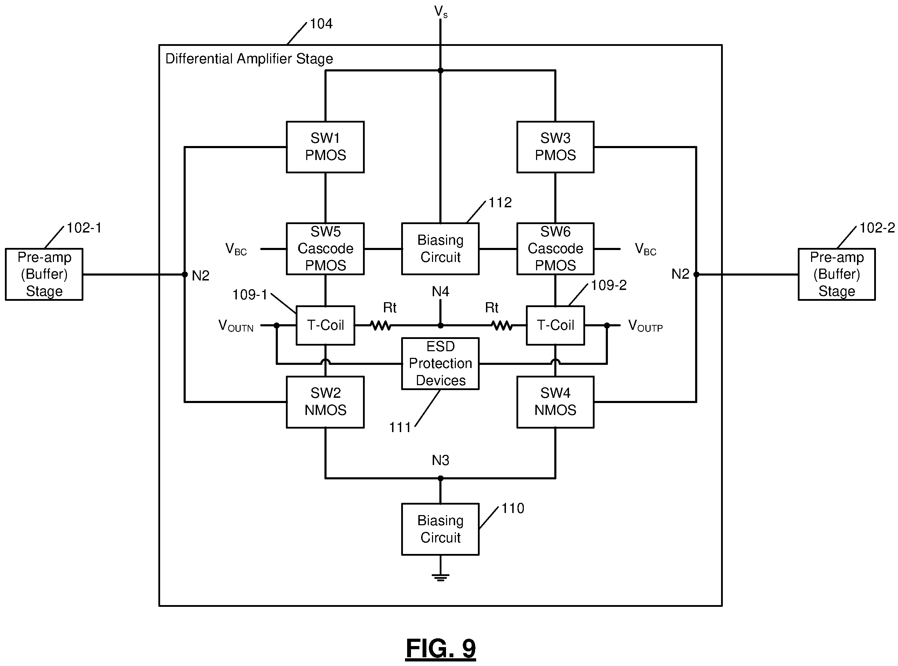

FIG. 9 shows the differential amplifier 104. The differential amplifier 104 comprises four switches SW1, SW2, SW3, and SW4, which include NMOS and PMOS switches. Additionally, the differential amplifier 104 comprises two cascode switches SW5 and SW6 (e.g., PMOS switches). The switches SW1 and SW3 are PMOS switches, and the switches SW2 and SW4 are NMOS switches. For convenience, the switches SW1 and SW2 are called the top left and bottom left switches, and the switches SW3 and SW4 are called top right and bottom right switches. The top two switches SW1 and SW3 are connected to the power supply Vs. The bottom two switches SW2 and SW4 are connected to a node N3 that is coupled to a reference potential via a biasing circuit (e.g., an NMOS switch) 110 used to bias the switches SW2 and SW4.

A biasing circuit 112 biases the cascode switches SW5 and SW6. The first cascode switch SW5 is connected between and in series with the top left and bottom left switches SW1 and SW2. The second cascode switch SW6 is connected between and in series with the top right and bottom right switches SW3 and SW4. The differential amplifier 104 outputs a first differential output at a first junction of the first cascode switch SW5 and the bottom left switch SW2. The differential amplifier 104 outputs a second differential output at a second junction of the second cascode switch SW6 and the bottom right switch SW4.

The differential amplifier 104 further comprises two termination resistors Rt that are connected in series with each other. A node at which the termination resistors Rt are connected to each other in series is called node N4. One end of the first termination resistor Rt opposite from the node N4 is coupled to the first junction (the first output of the differential amplifier 104) via a T-coil 109-1. One end of the second termination resistor Rt opposite from the node N4 is coupled to the second junction (the second output of the differential amplifier 104) via a T-coil 109-2. The differential outputs V_{OUTN} and V_{OUTP} of the differential amplifier 104 are delivered through respective termination resistors Rt and T-coils 109-1, 109-2 (collectively called the T-coils 109). The T-coils 109 isolate the differential amplifier 104 from electrostatic discharge (ESD) protection devices 111 that may be located across the differential outputs V_{OUTN} and V_{OUTP} of the differential amplifier 104. For example, the differential outputs V_{OUTN} and V_{OUTP} of the differential amplifier 104 are connected to pads of the chip comprising the driver 26, and the ESD protection devices 111 are connected to the pads inside the chip. The T-coils 109 also compensate for slow response arising from capacitive loading on the differential amplifier 104 from contact pads and ESD protection devices.

Due to the differential design of the differential amplifier 104, the control terminals (gates) of the top left and bottom left switches SW1 and SW2 are coupled to the node N2 in a first branch of the differential amplifier 104. The control terminals (gates) of the top right and bottom right switches SW3 and SW4 are coupled to an analog of the node N2 on the opposite side of the node N2 in a second branch of the differential amplifier 104. One output of the preamplifiers 102 is directly connected to the control terminals (gates) of the bottom left and bottom right switches SW2 and SW4 in the first branch of the differential amplifier 104. The other output of the preamplifiers 102 is connected through a high-speed AC coupling capacitor (not shown) to the control terminals (gates) of the top left and top right switches SW1 and SW3 in the second branch of the differential amplifier 104.

The cascode switches SW5 and SW6 in the respective branches of the differential amplifier 104 provide the following advantages. In the following description, only one cascode switch SW5 in the first branch of the differential amplifier 104is referenced. The description applies equally to the other cascode switch SW6 in the second branch of the differential amplifier 104. The cascode switch SW5 reduces the impact of Miller capacitance loading arising from the gate-to-drain capacitance of the switch SW1 (Cgd1) on the preceding preamplifier 102. Since the cascode node (drain of SW1) is isolated from the first output node V_{OUTN} of the differential amplifier 104 and experiences a smaller swing, Cgd1 does not experience a large swing and does not get amplified. A similar cascode could be constructed on the NMOS side (SW2) (e.g., by inserting an NMOS cascode switch between the first output node V_{OUTN} and the drain of SW2) to reap similar benefits. But to do so, the power supply voltage Vₛ would need to be increased, which would increase power consumption, and therefore can be avoided.

The cascode switch SW5 also ensures that the output impedance of the PMOS devices SW1 and SW5 do not impact the overall output impedance of the differential amplifier 104, which must be kept as close as possible to a fixed value (e.g., 50Ω) defined by the termination resistors Rt to reduce signal reflections and improve signal-integrity. Typically, the output impedance of CMOS devices varies widely due to process/voltage/temperature (PVT) variations. The cascode design ensures that the output impedance of the differential amplifier 104 defined by the termination resistors Rt is kept as immune to these variations as possible. Again, similar benefits could be reaped on the NMOS side (SW2) (e.g., by inserting an NMOS cascode switch between the first output node V_{OUTN} and the drain of SW2) if higher power supply voltage Vs used, which is avoided to keep the power consumption low.

Accordingly, the cascode switches SW5 and SW6 shield the preamplifiers 102 and the inputs of the differential amplifier 104 from being impacted by signal swings within the differential amplifier 104 due to capacitive effects. The cascode switches SW5 and SW6 in series with the top left and top right switches SW1 and SW3, respectively, also maintain the effective output impedance of the differential amplifier 104 defined by the termination resistances Rt nearly constant. Due to the above design, the differential amplifier 104 amplifies the outputs of the preamplifiers 102 while maintaining the linearity of the outputs and using a low supply voltage to reduce power consumption. The outputs of the differential amplifier 104 are supplied to subsequent circuits (e.g., the optical modulator 30 shown in FIG. 2).

FIG. 10 shows the balancing stage (also called the balancing circuit) 106 of the driver 26. The balancing circuit 106 balances voltages at various nodes of the driver 26 as follows. The balancing circuit 106 comprises three op-amp based circuits. A first op-amp circuit (called DAC op-amp) 150 is connected to the node N2. A second op-amp circuit 152 is connected to the node N3. A third op-amp circuit (called the output common mode or output CM op-amp) 154 is connected to the node N4. In addition to the high-speed circuit configurations described above, the three op-amp circuits 150, 152, 154 provide low-speed circuit configurations to ensure linear operation of the driver 26 as follows.

In the first op-amp circuit 150, the power supply voltage V_{DACS} provided to the DACs 24 and to the IV converters 100 is generated from the power supply Vs using a feedback loop comprising the DAC op-amp 150. A reference voltage V_{ref,DACS} and a voltage V_{SFout-cm} from the node N2 (the common mode output voltage of the source follower of the preamplifier 102) are input to the DAC op-amp 150. The output of the DAC op-amp 150 coupled to the power supply Vs (e.g., via a switch, not shown). The DAC op-amp 150 generates the power supply voltage V_{DACS}, which is provided to the DACs 24 and also to the IV converters 100 (as shown in FIG. 7), based on the inputs of the DAC op-amp 150. The output-to-input feedback loop of the DAC op-amp 150 ensures that the voltage V_{SFout-cm} from the node N2 does not vary widely due to PVT variations and does not bias the switches SW2 and SW4 of the differential amplifier 104 outside linear operating regions. Accordingly, the DAC op-amp 150 regulates the power supply voltage V_{DACS} at the node N2.

The second op-amp circuit 152 comprises an op-amp called a common-mode feedback (CMFB) op-amp 160 and a sensing circuit 162, which form a CMFB feedback loop at the output of the differential amplifier 104. The sensing circuit 162 senses the outputs V_{OUTN} and V_{OUTP} of the differential amplifier 104. The sensing circuit 162 generates a common mode (CM) output signal V_{out-cm-sense} that is fed to one input of the CMFB op-amp 160. A reference voltage for common mode feedback V_{ref,cmfb} is fed to another input of the CMFB op-amp 160. Based on the inputs, the CMFB op-amp 160 generates a feedback signal that is input to the node N3.

The CMFB loop at the output of the differential amplifier 104 ensures that a DC bias current of the NMOS switch (SW2) is equal to a DC bias current of the PMOS device (SW1) set by the biasing circuit 112 of the PMOS switches SW1 and SW3 and any DC current flowing through the termination resistors Rt. The CMFB loop (i.e., the feedback signal that is input to the node N3) controls the biasing circuit 110 used to bias the NMOS switches SW2 and SW4 in a deep triode region, with minimal voltage drop across the NMOS switch, which allows low voltage operation for low power dissipation.

In the third op-amp circuit 154, a reference voltage called output common mode reference voltage V_{ref,out-cm} is input to one input of the output CM op-amp 154. The other input of the output CM op-amp 154 is connected to the output of the output CM op-amp 154, which is connected to the node N4. The output CM op-amp 154 controls low frequency common-mode return loss of the driver 26 to mitigate common mode reflections from the outputs of the differential amplifier 104. The output CM op-amp 154 also creates a controllable voltage difference across the termination resistors Rt, which translates into a known DC bias current that can be added to or subtracted from the current of the PMOS switches that flows though the NMOS switches SW2 and SW4. The added or subtracted current balances the current ratio between the top PMOS switches and the bottom NMOS switches.

Accordingly, in the balancing circuit 106, the first op-amp circuit 150 is used to minimize DC voltage variation at the output (node N2) of the preamplifier 102 and to generate a conducive DC voltage required by NMOS devices (SW2, SW4) of the differential amplifier 104. By regulating the voltage at the node N2, the first op-amp circuit 150 improves the linearity of the driver 26. The second op-amp circuit 152 is used to minimize DC voltage variation at the node N3 and at the output of the differential amplifier 104 and to generate a conducive DC voltage required by the NMOS and PMOS devices (SW1 through SW6) of the differential amplifier 104. By regulating the voltage at the node N3, the second op-amp circuit 152 allows use of low power supply voltage Vs, which reduces the power dissipation. The third op-amp circuit 154 is connected to the node N4 in the differential amplifier 104 and is used to improve the common mode return loss and to create current offset between the bottom NMOS and the top PMOS branches of the differential amplifier 104. The voltage regulation at the node N4 performed by the third op-amp circuit 154 indirectly improves the linearity of the driver 26 by balancing the current ratio between the top PMOS switches and the bottom NMOS switches as described above.

Due to the above functions provided by the three op-amp circuits 150, 152, 154, the driver 26 operates linearly (i.e., without compromising the linearity provided by the DACs 24) at the output data rate of the DACs while operating at a low power supply voltage Vs, which keeps the power consumption low. As described above, the output swing of the driver 26 is controlled by controlling the bias voltage VB of the DACs 24. As shown in FIG. 5C and already described above, the output swing of the driver 26 varies linearly with the bias voltage VB of the DACs 24. Accordingly, the optical transmitter 12 can transmit data at higher data rates without replicating hardware (without duplicating the serializers 22 and the DACs 24), which saves cost and reduces power consumption of the optical transmitter 12.

The foregoing description is merely illustrative in nature and is not intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. Some or all blocks shown in the figures comprise circuits such as digital circuits, analog circuits, one or more processor circuits, and where applicable, a memory circuit storing code (instructions) executable by one or more processor circuits to provide the described functionality.

**The following is a list of further preferred embodiments of the invention:**
Embodiment 1. An optical transmitter comprising:
   a digital-to-analog converter (DAC) comprising switches configured to convert digital data into analog data that is modulated into an optical signal for transmission over an optical fiber;
   a timing circuit configured to generate timing signals to control the switches of the DAC; and
   circuitry configured to control an output data rate of the DAC by biasing the switches based on a logical combination of the digital data and the timing signals.
Embodiment 2. The optical transmitter of embodiment 1 wherein by the biasing of the switches of the DAC based on the logical combination of the digital data and the timing signals, the DAC outputs the analog data at the output data rate that is greater than a data rate of the digital data.
Embodiment 3. The optical transmitter of embodiment 1 wherein by the biasing of the switches of the DAC based on the logical combination of the digital data and the timing signals, the DAC outputs a current signal that is linear regardless of the output data rate of the DAC.
Embodiment 4. The optical transmitter of embodiment 1 wherein the timing circuit is configured to generate the timing signals with a phase difference and adjust the phase difference to control the output data rate of the DAC.
Embodiment 5. The optical transmitter of embodiment 4 wherein by adjusting the phase difference of the timing signals, the DAC outputs the analog data at the output data rate that is greater than a data rate of the digital data regardless of a pulse width of the digital data and pulse widths of the timing signals.
Embodiment 6. The optical transmitter of embodiment 1 wherein:
   the switches comprise a first switch connected in series to a second switch; and
   the circuitry comprises a combinational logic circuit configured to receive the digital data and the timing signals, output the logical combination of the digital data and the timing signals to control the first switch, and control the second switch by a first one of the timing signals.
Embodiment 7. The optical transmitter of embodiment 6 wherein the digital data supplies power to the combinational logic circuit.
Embodiment 8. The optical transmitter of embodiment 6 wherein the switches further comprise a third switch
   and a fourth switch and wherein:
   the third switch is connected to the first switch at a node and is biased to output a current signal comprising the analog data; and
   the fourth switch is connected to the node and is biased using a second one of the timing signals to pull up a voltage at the node when the first switch and the second switch turn off.
Embodiment 9. The optical transmitter of embodiment 8 further comprising a bias control circuit configured to control biasing of the third switch to control an output swing of the DAC.
Embodiment 10. An optical transmitter comprising:
   a plurality of digital-to-analog converters (DACs) configured to receive digital data at a first data rate and to output currents at a second data rate that is greater than the first data rate; and
   a driver configured to receive a combined current comprising the currents output by the DACs and to generate an output signal that is proportional to the combined current.
Embodiment 11. The optical transmitter of embodiment 10 further comprising:
   a timing circuit configured to generate timing signals to control the DACs; and
   circuitry configured to control the second data rate by biasing the DACs based on a logical combination of the digital data and the timing signals.
Embodiment 12. The optical transmitter of embodiment 11 wherein the timing circuit is configured to generate the timing signals with a phase difference and adjust the phase difference to control the second data rate.
Embodiment 13. The optical transmitter of embodiment 10 further comprising a bias control circuit configured to control biasing of the DACs, wherein an output swing of the driver varies linearly with the biasing of the DACs.
Embodiment 14. The optical transmitter of embodiment 10 wherein:
   the driver comprises a current-to-voltage converter configured to convert the combined current to a voltage signal and to compensate for capacitive loading from the DACs;
   a preamplifier configured to amplify the voltage signal and to lower an output impedance of the preamplifier;
   an amplifier configured to amplify an output of the preamplifier; and
   a balancing circuit configured to balance voltages at a plurality of nodes in the amplifier using a combination of feedback and reference voltages to maintain linearity of the output of the amplifier and to lower power consumption of the driver.
Embodiment 15. The optical transmitter of embodiment 14 wherein the current-to-voltage converter comprises a T-coil with a center tap configured to receive the combined current and to compensate for the capacitive loading from the DACs.
Embodiment 16. The optical transmitter of embodiment 14 wherein the preamplifier comprises a source follower configured to amplify the voltage signal and comprises an LC circuit forming a negative feedback loop configured to lower the output impedance of the preamplifier.
Embodiment 17. The optical transmitter of embodiment 14 wherein the amplifier comprises cascoded switches configured to reduce capacitive loading on the preamplifier.
Embodiment 18. The optical transmitter of embodiment 14 wherein the amplifier is configured to generate differential outputs via respective termination resistors, the amplifier comprising cascaded switches configured to maintain the output impedance of the amplifier defined by the termination resistors to reduce signal reflections in the differential outputs of the amplifier.
Embodiment 19. The optical transmitter of embodiment 14 wherein the amplifier is configured to generate differential outputs through a first set of switches arranged in a first branch and a second set of switches in a second branch and comprises:
   a first node (N2) defined by top and bottom switches in the first and second branches and configured to receive the output of the preamplifier;
   a second node (N3) defined by the bottom switches in the first and second branches and configured to bias the bottom switches;
   two termination resistors connected to each other at a third node (N4) and to the differential outputs, respectively; and
   cascode switches connected between the top and bottom switches in the first and second branches and biased to reduce capacitive loading on the preamplifier and to maintain the output impedance of the amplifier defined by the termination resistors.
Embodiment 20. The optical transmitter of embodiment 19 wherein to maintain linearity of the output of the amplifier and to lower power consumption of the driver, the balancing circuit comprises:
   a first circuit configured to generate a power supply voltage supplied to the DACs and the current-to-voltage converter and to regulate the power supply voltage at the first node (N2) to keep the bottom switches of the first and second branches within linear operating region;
   a second circuit configured to sense a common-mode output voltage of the amplifier and to generate a feedback signal that is input to the second node (N3), the feedback signal being configured to control biasing of the bottom switches in the first and second branches so that bias currents of the bottom switches are equal to bias currents of the cascode switches; and
   a third circuit coupled to the third node (N4) and configured to control low frequency common-mode return loss of the driver to mitigate common mode reflections from the differential outputs and to generate a controllable voltage difference across the termination resistors that provides a bias current to add to or subtract from currents of the cascode switches that flow though the bottom switches.
Embodiment 21. The optical transmitter of embodiment 14 wherein the amplifier is configured to generate differential outputs via respective T-coils configured to isolate the differential outputs from external electrostatic discharge (ESD) protection devices and to reduce capacitive loading on the differential outputs from the ESD devices.

## Claims

1. An optical transmitter comprising:
a digital-to-analog converter (DAC) comprising switches configured to convert digital data into analog data that is modulated into an optical signal for transmission over an optical fiber;
a timing circuit configured to generate timing signals to control the switches of the DAC; and
circuitry configured to control an output data rate of the DAC by biasing the switches based on a logical combination of the digital data and the timing signals.

2. The optical transmitter of claim 1 wherein by the biasing of the switches of the DAC based on the logical combination of the digital data and the timing signals, the DAC outputs the analog data at the output data rate that is greater than a data rate of the digital data.

3. The optical transmitter of claim one of claims 1 or 2 wherein by the biasing of the switches of the DAC based on the logical combination of the digital data and the timing signals, the DAC outputs a current signal that is linear regardless of the output data rate of the DAC.

4. The optical transmitter of one of claims 1 to 3 wherein the timing circuit is configured to generate the timing signals with a phase difference and adjust the phase difference to control the output data rate of the DAC, and/or
wherein by adjusting the phase difference of the timing signals, the DAC outputs the analog data at the output data rate that is greater than a data rate of the digital data regardless of a pulse width of the digital data and pulse widths of the timing signals.

5. The optical transmitter of one of claims 1 to 4 wherein:
the switches comprise a first switch connected in series to a second switch; and
the circuitry comprises a combinational logic circuit configured to receive the digital data and the timing signals, output the logical combination of the digital data and the timing signals to control the first switch, and control the second switch by a first one of the timing signals, and/or
wherein the digital data supplies power to the combinational logic circuit.

6. The optical transmitter of claim 5 wherein the switches further comprise a third switch and a fourth switch and wherein:
the third switch is connected to the first switch at a node and is biased to output a current signal comprising the analog data; and
the fourth switch is connected to the node and is biased using a second one of the timing signals to pull up a voltage at the node when the first switch and the second switch turn off, and/or
further comprising a bias control circuit configured to control biasing of the third switch to control an output swing of the DAC.

7. An optical transmitter comprising:
a plurality of digital-to-analog converters (DACs) configured to receive digital data at a first data rate and to output currents at a second data rate that is greater than the first data rate; and
a driver configured to receive a combined current comprising the currents output by the DACs and to generate an output signal that is proportional to the combined current.

8. The optical transmitter of claim 7 further comprising:
a timing circuit configured to generate timing signals to control the DACs; and
circuitry configured to control the second data rate by biasing the DACs based on a logical combination of the digital data and the timing signals.

9. The optical transmitter of claim 8 wherein the timing circuit is configured to generate the timing signals with a phase difference and adjust the phase difference to control the second data rate.

10. The optical transmitter of claim 7 or 9 further comprising a bias control circuit configured to control biasing of the DACs, wherein an output swing of the driver varies linearly with the biasing of the DACs.

11. The optical transmitter of one of claims 7 to 10 wherein:
the driver comprises a current-to-voltage converter configured to convert the combined current to a voltage signal and to compensate for capacitive loading from the DACs;
a preamplifier configured to amplify the voltage signal and to lower an output impedance of the preamplifier;
an amplifier configured to amplify an output of the preamplifier; and
a balancing circuit configured to balance voltages at a plurality of nodes in the amplifier using a combination of feedback and reference voltages to maintain linearity of the output of the amplifier and to lower power consumption of the driver.

12. The optical transmitter of claim 11 wherein the current-to-voltage converter comprises a T-coil with a center tap configured to receive the combined current and to compensate for the capacitive loading from the DACs, or
wherein the preamplifier comprises a source follower configured to amplify the voltage signal and comprises an LC circuit forming a negative feedback loop configured to lower the output impedance of the preamplifier, or
wherein the amplifier comprises cascoded switches configured to reduce capacitive loading on the preamplifier, or
wherein the amplifier is configured to generate differential outputs via respective termination resistors, the amplifier comprising cascaded switches configured to maintain the output impedance of the amplifier defined by the termination resistors to reduce signal reflections in the differential outputs of the amplifier.

13. The optical transmitter of claim 11 or 12 wherein the amplifier is configured to generate differential outputs through a first set of switches arranged in a first branch and a second set of switches in a second branch and comprises:
a first node (N2) defined by top and bottom switches in the first and second branches and configured to receive the output of the preamplifier;
a second node (N3) defined by the bottom switches in the first and second branches and configured to bias the bottom switches;
two termination resistors connected to each other at a third node (N4) and to the differential outputs, respectively; and
cascode switches connected between the top and bottom switches in the first and second branches and biased to reduce capacitive loading on the preamplifier and to maintain the output impedance of the amplifier defined by the termination resistors.

14. The optical transmitter of claim 13wherein to maintain linearity of the output of the amplifier and to lower power consumption of the driver, the balancing circuit comprises:
a first circuit configured to generate a power supply voltage supplied to the DACs and the current-to-voltage converter and to regulate the power supply voltage at the first node (N2) to keep the bottom switches of the first and second branches within linear operating region;
a second circuit configured to sense a common-mode output voltage of the amplifier and to generate a feedback signal that is input to the second node (N3), the feedback signal being configured to control biasing of the bottom switches in the first and second branches so that bias currents of the bottom switches are equal to bias currents of the cascode switches; and
a third circuit coupled to the third node (N4) and configured to control low frequency common-mode return loss of the driver to mitigate common mode reflections from the differential outputs and to generate a controllable voltage difference across the termination resistors that provides a bias current to add to or subtract from currents of the cascode switches that flow though the bottom switches.

15. The optical transmitter of one of claims 11 to 14 wherein the amplifier is configured to generate differential outputs via respective T-coils configured to isolate the differential outputs from external electrostatic discharge (ESD) protection devices and to reduce capacitive loading on the differential outputs from the ESD devices.
